# EUROPEAN PATENT APPLICATION

(11) **EP 4 472 369 A1**
(43) Date of publication of application: **04.12.2024**
(21) Application number: 24169243.3
(22) Date of filing: 09.04.2024
(51) Int. Cl.: H05K 7/14

(54) **ELECTRONIC DEVICE**

(30) Priority: 29.05.2023 JP 2023088093
(71) Applicant: Yokogawa Electric Corporation, Tokyo 180-8750 (JP)
(72) Inventor: EBINE, Ryo, Musashino-shi, Tokyo 180-8750, (JP); HAMADA, Taihei, Musashino-shi, Tokyo 180-8750, (JP)
(74) Representative: Stöckeler, Ferdinand

(57) **Abstract**

An electronic device includes a container, a partition wall dividing a space within the container, a through-hole provided in the partition wall, an electrical connection component attached to the partition wall so as to be removable from the container and having an insertion portion inserted into the through-hole, a first electronic component attachable to the electrical connection component on one side of the partition wall so as to be removable from the container, and a second electronic component attachable to the electrical connection component on another side of the partition wall so as to be removable from the container. The first electronic component and the second electronic component can be electrically connected to each other via the electrical connection component by each being attached to the electrical connection component.

## Description

### TECHNICAL FIELD

The present disclosure relates to an electronic device.

### BACKGROUND

A known electronic device includes a container, a partition wall dividing a space within the container, a through-hole provided in the partition wall, an electrical connection component attached to the partition wall and having an insertion portion inserted into the through-hole, a first electronic component attached to the electrical connection component on one side of the partition wall, and a second electronic component attached to the electrical connection component on the other side of the partition wall, wherein the first electronic component and the second electronic component can be electrically connected to each other via the electrical connection component by each being attached to the electrical connection component. See, for example, Patent Literature (PTL) 1.

### CITATION LIST

### Patent Literature

PTL 1: JP S53-031449 U

### SUMMARY

An electronic device such as the one described above preferably allows the electrical connection component, the first electronic component, and the second electronic component to be removed separately from the container during disposal, maintenance, or the like.

It would be helpful to provide an electronic device such that an electrical connection component, a first electronic component, and a second electronic component can be separately removed from a container.

Aspects of the present disclosure are as follows.
[1] An electronic device including:
   a container;
   a partition wall dividing a space within the container;
   a through-hole provided in the partition wall;
   an electrical connection component attached to the partition wall so as to be removable from the container and having an insertion portion inserted into the through-hole;
   a first electronic component attachable to the electrical connection component on one side of the partition wall so as to be removable from the container; and
   a second electronic component attachable to the electrical connection component on another side of the partition wall so as to be removable from the container, wherein
   the first electronic component and the second electronic component can be electrically connected to each other via the electrical connection component by each being attached to the electrical connection component.
[2] The electronic device recited in [1], wherein the container includes
   a container body forming a first opening through which the first electronic component can pass at the one side of the partition wall, and
   a first lid capable of opening the first opening.
[3] The electronic device recited in [2], wherein the first opening is configured to allow the electrical connection component to pass through the first opening.
[4] The electronic device recited in [2] or [3], wherein
   the container body forms a second opening through which the second electronic component can pass at the other side of the partition wall, and
   the container includes a second lid capable of opening the second opening.
[5] The electronic device recited in any one of [1] to [4], wherein one of the first electronic component and the second electronic component is an amplifier component and the other of the first electronic component and the second electronic component is a terminal component.
[6] The electronic device recited in any one of [1] to [5], wherein the first electronic component includes a substrate and a first connector mounted on the substrate, and the first electronic component is fixed to the partition wall by being attached to the electrical connection component via the first connector.
[7] The electronic device recited in any one of [1] to [6], wherein the second electronic component includes a substrate and a second connector mounted on the substrate, and the second electronic component is fixed to the partition wall by being attached to the electrical connection component via the second connector.
[8] The electronic device recited in any one of [1] to [7], further including a partition wall sealing member surrounding the insertion portion of the electrical connection component so as to seal a gap between the partition wall and the electrical connection component.
[9] The electronic device recited in any one of [1] to [8], wherein
   the container includes a container body forming a first opening through which the first electronic component can pass at the one side of the partition wall and a second opening through which the second electronic component can pass at the other side of the partition wall, a first lid capable of opening the first opening, and a second lid capable of opening the second opening,
   the container body includes the partition wall, and
   the container body, the first lid, the second lid, and the electrical connection component form an explosion-proof structure.
[10] The electronic device recited in any one of [1] to [9], wherein the electronic device is configured as a field device.

According to the present disclosure, an electronic device such that an electrical connection component, a first electronic component, and a second electronic component can be separately removed from a container can be provided.

### BRIEF DESCRIPTION OF THE DRAWINGS

In the accompanying drawings:

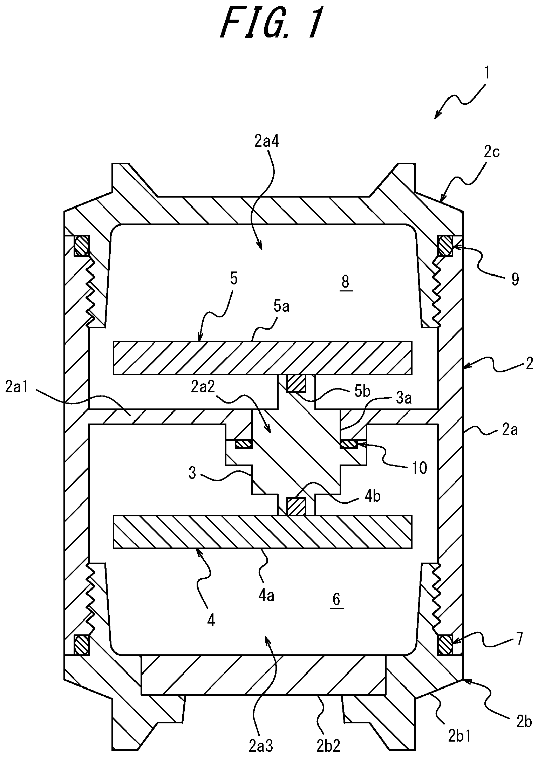

FIG. 1 is a cross-sectional diagram illustrating an electronic device in an embodiment of the present disclosure.

### DETAILED DESCRIPTION

Embodiments of the present disclosure are illustrated below with reference to the drawings.

As illustrated in FIG. 1, in an embodiment of the present disclosure, an electronic device 1 includes a container 2, a partition wall 2a1 dividing a space within the container 2, a through-hole 2a2 provided in the partition wall 2a1, an electrical connection component 3 attached to the partition wall 2a1 so as to be removable from the container 2 and having an insertion portion 3a inserted into the through-hole 2a2, a first electronic component 4 attachable to the electrical connection component 3 on one side of the partition wall 2a1 so as to be removable from the container 2, and a second electronic component 5 attachable to the electrical connection component 3 on another side of the partition wall 2a1 so as to be removable from the container 2. The first electronic component 4 and the second electronic component 5 can be electrically connected to each other via the electrical connection component 3 by each being attached to the electrical connection component 3.

According to the above configuration, the first electronic component 4 can be detached from the electrical connection component 3 on one side of the partition wall 2a1 and removed from the container 2, the second electronic component 5 can be detached from the electrical connection component 3 on the other side of the partition wall 2a1 and removed from the container 2, and the electrical connection component 3 attached to the partition wall 2a1 can be removed from the container 2. The electrical connection component 3, the first electronic component 4, and the second electronic component 5 can therefore be separately removed from the container 2. As a result, the container 2, the electrical connection component 3, the first electronic component 4, and the second electronic component 5 can be sorted by material at the time of disposal, for example, and in a case in which the first electronic component 4 and the second electronic component 5 are of different materials, the first electronic component 4 and the second electronic component 5 can be sorted. Furthermore, the electrical connection component 3, the first electronic component 4, or the second electronic component 5 can, for example, be individually removed from the container 2 for repair or replacement as necessary during periodic maintenance, repair, or the like.

The electrical connection component 3 enables power supply, analog or digital communication, or any combination thereof, for example, between the first electronic component 4 and the second electronic component 5 via the electrical connection between the first electronic component 4 and the second electronic component 5.

The container 2 includes a container body 2a, made of metal or the like, forming a first opening 2a3 through which the first electronic component 4 can pass at the one side of the partition wall 2a1, and a first lid 2b capable of opening the first opening 2a3. According to this configuration, a closed first chamber 6 can be formed on one side of the partition wall 2a1 by closing the first opening 2a3 of the container body 2a with the first lid 2b, and the first chamber 6 can be opened by the first lid 2b to remove the first electronic component 4 from the container 2 through the first opening 2a3.

The electronic device 1 includes a first lid sealing member 7 formed, for example, of an elastic material that seals the first chamber 6 by the first opening 2a3 of the container body 2a being closed by the first lid 2b. According to this configuration, the sealing property of the first lid 2b can be improved.

The first lid 2b includes a lid body 2b 1 made of metal or the like and a transparent window 2b2 made of glass or the like. According to this configuration, the inside of the first chamber 6 is visible from the outside while the first chamber 6 is closed.

The first opening 2a3 is configured to allow the electrical connection component 3 to pass through the first opening 2a3. According to this configuration, the electrical connection component 3 can be removed from the container 2 through the first opening 2a3 by opening the first lid 2b.

The container body 2a forms a second opening 2a4 through which the second electronic component 5 can pass at the other side of the partition wall 2a1, and the container 2 includes a second lid 2c capable of opening the second opening 2a4. According to this configuration, a closed second chamber 8 can be formed on the other side of the partition wall 2a1 by closing the second opening 2a4 of the container body 2a with the second lid 2c, and the second chamber 8 can be opened by the second lid 2c to remove the second electronic component 5 from the container 2 through the second opening 2a4.

The electronic device 1 includes a second lid sealing member 9 formed, for example, of an elastic material that seals the second chamber 8 by the second opening 2a4 of the container body 2a being closed by the second lid 2c. According to this configuration, the sealing property of the second lid 2c can be improved.

The first electronic component 4 may be configured to be attachable to the container body 2a by a fixing member for the first electronic component, such as a screw. According to this configuration, the first electronic component 4 can be fixed to the container body 2a by the fixing member for the first electronic component, and the fixation by the fixing member for the first electronic component can be released for detachment of the first electronic component 4 from the container body 2a and removal from the container 2.

The electrical connection component 3 may be configured to be attachable to the container body 2a by a fixing member for the electrical connection component, such as a screw. According to this configuration, the electrical connection component 3 can be fixed to the container body 2a by the fixing member for the electrical connection component, and the fixation by the fixing member for the electrical connection component can be released for detachment of the electrical connection component 3 from the container body 2a and removal from the container 2.

The second electronic component 5 may be configured to be attachable to the container body 2a by a fixing member for the second electronic component, such as a screw. According to this configuration, the second electronic component 5 can be fixed to the container body 2a by the fixing member for the second electronic component, and the fixation by the fixing member for the second electronic component can be released for detachment of the second electronic component 5 from the container body 2a and removal from the container 2.

One of the first electronic component 4 and the second electronic component 5 may be an amplifier component, and the other of the first electronic component 4 and the second electronic component 5 may be a terminal component. According to this configuration, the amplifier component and the terminal component can be sorted at the time of disposal. The amplifier component transmits an electrical signal to the terminal component, for example. The terminal component transmits electric power to the amplifier component, for example.

The first electronic component 4 includes a substrate 4a and a first connector 4b mounted on the substrate 4a, and the first electronic component 4 is fixed to the partition wall 2a1 by being attached to the electrical connection component 3 via the first connector 4b. According to this configuration, mounting and electrical connection of the first electronic component 4 to the electrical connection component 3 can be achieved by a simple structure using the first connector 4b mounted on the substrate 4a.

The second electronic component 5 includes a substrate 5a and a second connector 5b mounted on the substrate 5a, and the second electronic component 5 is fixed to the partition wall 2a1 by being attached to the electrical connection component 3 via the second connector 5b. According to this configuration, mounting and electrical connection of the second electronic component 5 to the electrical connection component 3 can be achieved by a simple structure using the second connector 5b mounted on the substrate 5a.

The electronic device 1 includes a partition wall sealing member 10 that surrounds the insertion portion 3a of the electrical connection component 3 so as to seal the gap between the partition wall 2a1 and the electrical connection component 3 and that is formed of an elastic material, for example. According to this configuration, the sealing property of the partition wall 2a1 can be improved.

The container 2 includes the container body 2a forming the first opening 2a3 through which the first electronic component 4 can pass at the one side of the partition wall 2a1 and the second opening 2a4 through which the second electronic component 5 can pass at the other side of the partition wall 2a1, the first lid 2b capable of opening the first opening 2a3, and the second lid 2c capable of opening the second opening 2a4. The container body 2a includes the partition wall 2a1, and the container body 2a, the first lid 2b, the second lid 2c, and the electrical connection component 3 form an explosion-proof structure. According to the above configuration, an electronic device 1 that satisfies explosion-proof regulations can be realized.

The electronic device 1 is, for example, a differential pressure/pressure transmitter, a temperature transmitter, an electromagnetic, vortex, Coriolis, or ultrasonic flow meter, or the like. The electrical connection between the first electronic component 4 and the second electronic component 5 of the electronic device 1 via the electrical connection component 3 is a 2-wire system, for example, and achieves analog communication, such as 4-20 mA current output, or digital communication, such as FF or Profi, by a power supply from a commercial power source or the like, for example.

The electronic device 1 may be configured as a field device. According to this configuration, a field device such that the electrical connection component 3, the first electronic component 4, and the second electronic component 5 can be separately removed from the container 2 can be achieved.

Field devices are electronic devices 1 used in a plant. The plant is an industrial plant such as a chemical plant; a plant for managing a well site, such as a gas field or oil field, and the surrounding area; a plant for managing power generation such as hydroelectric power, thermal power, nuclear power, or the like; a plant for managing environmental power generation such as solar power, wind power, or the like; a plant for managing water and sewage, a dam, or the like; or another type of plant.

Field devices are often composed of parts made of different materials such as metals and resins, which can be disassembled, sorted, and recovered for reuse if necessary. Hundreds of thousands to millions of field devices are produced per year in the market overall, and it is assumed that a similar number of field devices are disposed of. Whether field devices can be sorted at the time of disposal is of great importance in terms of impact on the global environment.

The present disclosure is not limited to the above-described embodiments and can be modified in various ways without departing from the scope thereof.

## Claims

1. An electronic device comprising:
a container;
a partition wall dividing a space within the container;
a through-hole provided in the partition wall;
an electrical connection component attached to the partition wall so as to be removable from the container and having an insertion portion inserted into the through-hole;
a first electronic component attachable to the electrical connection component on one side of the partition wall so as to be removable from the container; and
a second electronic component attachable to the electrical connection component on another side of the partition wall so as to be removable from the container, wherein
the first electronic component and the second electronic component can be electrically connected to each other via the electrical connection component by each being attached to the electrical connection component.

2. The electronic device according to claim 1, wherein the container includes
a container body forming a first opening through which the first electronic component can pass at the one side of the partition wall, and
a first lid capable of opening the first opening.

3. The electronic device according to claim 2, wherein the first opening is configured to allow the electrical connection component to pass through the first opening.

4. The electronic device according to claim 2, wherein
the container body forms a second opening through which the second electronic component can pass at the other side of the partition wall, and
the container includes a second lid capable of opening the second opening.

5. The electronic device according to claim 1, wherein one of the first electronic component and the second electronic component is an amplifier component and the other of the first electronic component and the second electronic component is a terminal component.

6. The electronic device according to claim 1, wherein the first electronic component includes a substrate and a first connector mounted on the substrate, and the first electronic component is fixed to the partition wall by being attached to the electrical connection component via the first connector.

7. The electronic device according to claim 1, wherein the second electronic component includes a substrate and a second connector mounted on the substrate, and the second electronic component is fixed to the partition wall by being attached to the electrical connection component via the second connector.

8. The electronic device according to claim 1, further comprising a partition wall sealing member surrounding the insertion portion of the electrical connection component so as to seal a gap between the partition wall and the electrical connection component.

9. The electronic device according to claim 1, wherein
the container includes a container body forming a first opening through which the first electronic component can pass at the one side of the partition wall and a second opening through which the second electronic component can pass at the other side of the partition wall, a first lid capable of opening the first opening, and a second lid capable of opening the second opening,
the container body includes the partition wall, and
the container body, the first lid, the second lid, and the electrical connection component form an explosion-proof structure.

10. The electronic device according to claim 1, wherein the electronic device is configured as a field device.
